(19)

Europäisches
Patentamt

European
Patent Office

Office européen
des brevets

(11) **EP 4 752 582 A1**

(12) **EUROPEAN PATENT APPLICATION**

(43) Date of publication:
**03.06.2026 Bulletin 2026/23**

(21) Application number: **24216531.4**

(22) Date of filing: **29.11.2024**

(51) International Patent Classification (IPC):
**G01R 31/64** (2020.01)    **G01R 19/165** (2006.01)
**G01R 31/40** (2020.01)

(52) Cooperative Patent Classification (CPC):
**G01R 19/165; G01R 31/40; G01R 31/64**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(71) Applicant: **ABB SCHWEIZ AG**
**5400 Baden (CH)**

(72) Inventors:
• **Kukkola, Jarno**
  **00380 Helsinki (FI)**
• **Eskola, Matti**
  **00380 Helsinki (FI)**

(74) Representative: **Kolster Oy Ab**
**Salmisaarenaukio 1**
**P.O. Box 204**
**00181 Helsinki (FI)**

(54) **ESTIMATING PARAMETER VALUES OF AN INTERMEDIATE CIRCUIT**

(57)    Disclosed is a method comprising discharging electrical energy from an intermediate circuit comprised in the apparatus; measuring a direct current voltage; inputting measured values to a parameter estimator for the intermediate circuit, wherein the parameter estimator comprises at least a first parameter and a second parameter whose values are determined based on an equivalent capacitance value of the intermediate circuit, an equivalent resistance value of the intermediate circuit and an electrical load power value of the intermediate circuit, the parameter estimator outputting values for time constant and values for power-to-capacitance ratio of the intermediate circuit; and storing values at least temporarily for condition monitoring.

| 501 | Discharge electrical energy |
|---|---|
| 502 | Measure voltage |
| 503 | Input voltage values to parameter estimator which output values |
| 504 | Store at least temporarily one or more of the outputted 1st and 2nd values |

**FIG. 5**

EP 4 752 582 A1

**Description**

FIELD

The following exemplary embodiments relate to obtaining values for condition monitoring.

BACKGROUND

Intermediate circuits, for example DC intermediate circuits in variable speed drives, comprise capacitors that serve as energy buffers for power fluctuations during operation. Capacitors are known to degrade over time and degraded capacitors increase the risk of unexpected failure of the drive. To minimize the risk, the capacitors may be replaced at predefined intervals, which means that capacitors still having lifetime are replaced too early. There have been proposals to monitor condition of intermediate circuits by measuring current and voltage, but they have practical limitations including need for high number of monitoring sensors. It would be beneficial to find a solution with less limitations.

SUMMARY

According to an aspect, there is provided a computer-implemented method comprising: discharging, when alternating current, AC, is not supplied to an apparatus, electrical energy from an intermediate circuit comprised in the apparatus; measuring, during the discharging, a direct current, DC, voltage of the intermediate circuit; when the DC voltage of the intermediate circuit is below a first threshold value and above a second threshold value, inputting measured DC voltage values to a parameter estimator for the intermediate circuit, wherein the parameter estimator comprises at least a first parameter and a second parameter whose values are determined based on an equivalent capacitance value of the intermediate circuit, an equivalent resistance value of the intermediate circuit and an electrical load power value of the intermediate circuit, the parameter estimator outputting at least first values for time constant, and second values for power-to-capacitance ratio of the intermediate circuit; when the DC voltage of the intermediate circuit decreases below the second threshold value, storing, for condition monitoring, at least temporarily in at least one memory, at least one value for the time constant and at least one value for the power-to-capacitance ratio.

According to an aspect, there is provided an apparatus comprising: an intermediate circuit; a parameter estimator for the intermediate circuit, the parameter estimator comprising at least a first parameter and a second parameter whose values are determined based on an equivalent capacitance value of the intermediate circuit, an equivalent resistance value of the intermediate circuit and an electrical load power value of the intermediate circuit, the parameter estimator outputting at least first values for time constant, and second values for power-to-capacitance ratio of the intermediate circuit; means for discharging, when alternating current, AC, is not supplied to the apparatus, electrical energy from the intermediate circuit; means for measuring, during the discharging, a direct current, DC, voltage of the intermediate circuit; means for inputting, when the DC voltage of the intermediate circuit is below a first threshold value and above a second threshold value, the measured DC voltage values to the parameter estimator; means for storing, when the DC voltage of the intermediate circuit decreases below the second threshold value, for condition monitoring, at least one value for the time constant and at least one value for the power-to-capacitance ratio and at least temporarily an equivalent capacitance value.

According to an aspect, there is provided a computer program comprising instructions which, when the program is executed by a computer, cause the computer to carry out: discharging, when alternating current, AC, is not supplied to an apparatus, electrical energy from an intermediate circuit comprised in the apparatus; measuring, during the discharging, a direct current, DC, voltage of the intermediate circuit; when the DC voltage of the intermediate circuit is below a first threshold value and above a second threshold value, inputting measured DC voltage values to a parameter estimator for the intermediate circuit, wherein the parameter estimator comprises at least a first parameter and a second parameter whose values are determined based on an equivalent capacitance value of the intermediate circuit, an equivalent resistance value of the intermediate circuit and an electrical load power value of the intermediate circuit, the parameter estimator outputting at least first values for time constant, and second values for power-to-capacitance ratio of the intermediate circuit; when the DC voltage of the intermediate circuit decreases below the second threshold value, storing, for condition monitoring, at least temporarily in at least one memory, at least one value for the time constant and at least one value for the power-to-capacitance ratio.

BRIEF DESCRIPTION OF THE DRAWINGS

In the following the invention will be described in greater detail by means of exemplary embodiments with reference to the accompanying drawings, in which

FIG. 1 illustrates a simplified system;
FIG. 2 illustrates an intermediate circuit model;
FIG. 3 illustrates an equivalent circuit model;
FIG. 4 illustrates an intermediate circuit model;
FIG. 5 illustrates a flowchart according to an exemplary embodiment;
FIG. 6 illustrates a flowchart according to an exemplary embodiment;
FIG. 7 illustrates a flowchart according to an exemplary embodiment;
FIG. 8 illustrates a flowchart according to an exemplary embodiment;
FIG. 9 illustrates a flowchart according to an exemplary embodiment;
FIG. 10 illustrates a flowchart according to an exemplary embodiment;
FIG. 11 illustrates an apparatus according to an exemplary embodiment.

DETAILED DESCRIPTION

The following embodiments are exemplary. Although the specification may refer to "an", "one", or "some" embodiment(s) in several locations of the text, this does not necessarily mean that each such reference is made to the same embodiment(s), or that a particular feature only applies to a single embodiment. Single features of different embodiments may also be combined to provide other embodiments.

Various exemplary embodiments may be applicable to any circuit comprising capacitors and being placeable to an electronic device, and electronic devices comprising such circuits.

Different embodiments and examples are described below using single units, models, equipment and memory, without restricting the embodiments/examples to such a solution. Concepts called cloud computing and/or virtualization may be used. Virtualization may allow a single physical computing device to host one or more instances of virtual machines that appear and operate as independent computing devices, so that a single physical computing device can create, maintain, delete, or otherwise manage virtual machines in a dynamic manner. It is also possible that device operations will be distributed among a plurality of servers, nodes, devices or hosts. In cloud computing network devices, computing devices and/or storage devices provide shared resources. Some other technology advancements, such as Software-Defined Networking (SDN) may cause one or more of the functionalities described below to be migrated to any corresponding abstraction or apparatus or device. Therefore, all words and expressions should be interpreted broadly, and they are intended to illustrate, not to restrict, the exemplary embodiments.

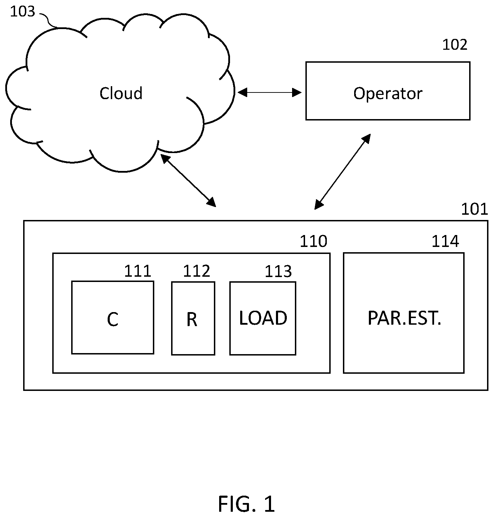

FIG. 1 illustrates a simplified system only showing some elements and functional entities, all being logical units whose implementation may differ from what is shown. The connections shown in FIG. 1 are logical connections; the actual physical connections may be different. It is apparent to a person skilled in the art that the system and its apparatuses also comprise other functions and structures.

In the illustrated example of FIG. 1, the system comprises one or more apparatuses 101 (only one shown in FIG. 1), an operator equipment 102, and a cloud 103.

The apparatus 101 may be a variable speed drive, and terms drive, variable speed drive and apparatus are used herein as synonyms without limiting the examples to variable speed drives. The variable speed drive 101 may also be referred to as a variable frequency drive or frequency converter. The variable speed drive 101 may be used to run machinery, such as pump, fan and conveyor. The variable speed drive 101 may be electrically connected to the machinery not illustrated in FIG. 1. The variable speed drive 101 may comprise a disconnection device (not illustrated in FIG.1), e.g., switch and/or contactor, via which the variable speed drive may be connected to and disconnected from an AC supply network, AC or DC chokes (not illustrated in FIG. 1), charging circuits (not illustrated in FIG.1), a rectifier bridge (not illustrated in FIG. 1), an inverter bridge (not illustrated in FIG. 1) and an intermediate circuit 110 between the rectifier bridge and the inverter bridge. The variable speed drive 101 may comprise a parameter estimator 114.

In the illustrated example of FIG. 1, the intermediate circuit 110 comprises at least a capacitor bank 111, balancing/discharge resistors 112, and electronics 113. Electronics 113 may be active and/or passive electrical loads. Electrical load may also be referred as an internal electrical load. The intermediate circuit 110 may further comprise DC chokes (not illustrated in FIG. 1) and/or the charging circuits (not illustrated in FIG. 1).

The capacitor bank 111 may comprise multiple capacitor sub-banks which may be connected in series and/or parallel, as will be described in more detail below.

Electronics 113 may comprise one or more power supplies, one or more control boards, one or more interfaces, and/or one or more cooling fans, for example.

In the illustrated example of FIG. 1, the parameter estimator 114 is illustrated as a separate entity but it may also be a part of the electronics 113. The parameter estimator 114 is a tool, e.g. an application, comprising parameters estimating values usable for condition monitoring of the intermediate circuit 110, as will be described in more detail below. The parameters may be based on an equivalent capacitance based of the capacitor bank 111 of the intermediate circuit 110, an equivalent resistance value based on the balancing/discharge resistors 112 of the intermediate circuit 110 and an electrical load power based on the internal electrical loads caused by the electronics 113 of the intermediate circuit 110, as will be described in more detail below. The inputs to the parameter estimator 114 comprise voltage values and the parameter estimator outputs at least values for a time constant of the intermediate circuit and values for a power-to-capacitance ratio, as will be described in more detail below. The parameter estimator 114 is configured to be run, or at least collect voltage values, when the variable speed drive 110 is disconnected from the AC supply network and is in a stopped state. Hence, the parameter estimator 114 may also cause, when run, electrical load. The parameter estimator 114 may be ran several times during the life-time of the variable speed drive 101 or during the lifetime of the intermediate circuit and it may be ran at regular and/or irregular intervals. For example, the parameter estimator 114 may be ran once per week or once per month. In some exemplary embodiment, the parameter estimator 114 may use batch-processing in which the input data is stored while being collected, and input later to the parameter estimator 114. The batch-processing method may be used when memory consumption does not need to be optimized. Input data collection may use internal measurement capability of the variable speed drive 101. The electronics and control boards of the intermediate circuit 114 and/or variable speed drive 101 are capable of measuring DC-voltage using resistive voltage-division networks, analog-to-digital converters, and internal microprocessor (s) of the drive, for example.

As illustrated in FIG. 1, the variable speed drive 101, and thereby the intermediate circuit 110, may be connected to the operator equipment 102, directly and/or via the cloud 103. The connections between the variable speed drive 101, the operator equipment 102, and/or the cloud 103 may be based on wireless communications, such as 3G (third generation), 4G (fourth generation), LTE (long term evolution), LTE-A (long term evolution advanced), 5G (fifth generation), 5G NR (new radio), UMTS (universal mobile telecommunications system), EDGE (enhanced data rates for GSM evolution), WCDMA (wideband code division multiple access), Bluetooth, WLAN (wireless local area network), Wi-Fi, Li-Fi (light fidelity) or any other mobile or wireless network. The communication may also occur between nodes belonging to different but compatible systems, such as LTE and 5G. Alternatively, some exemplary embodiments may be based on wired connections, at least partly. It should be appreciated that the functions, structures, elements, and protocols used in or for communication are irrelevant to the exemplary embodiments. Therefore, they need not be discussed in more detail here.

The operator equipment 102, or part of it, may locate in a control room on a site the variable speed drive 101 locates, or in a remote service center, for example. The operator equipment 102 may comprise computing devices, e.g. computers or servers, and user interfaces for monitoring and for user interactions, for example. The details of implementation, purpose and actual functionality of the operator equipment, and/or how the operator equipment accesses and uses data obtained e.g. from the parameter estimator, are irrelevant for the exemplary embodiments, and therefore they are not described in more detail here.

The cloud 103 represents herein an example of a platform and devices (servers) on which data, e.g. may be stored and accessed. For example, the variable speed drive 101 may be configured to transmit measured data, parameter estimator output(s), warning and failure logs, real-time operational information, etc., to the cloud 103. The cloud 103 may further provide resources for cloud computing. The details of how data are stored in the cloud or in any other data storage are not relevant and therefore they are not described in more detail here. It is obvious for one skilled in the art that any known or future storage method may be used.

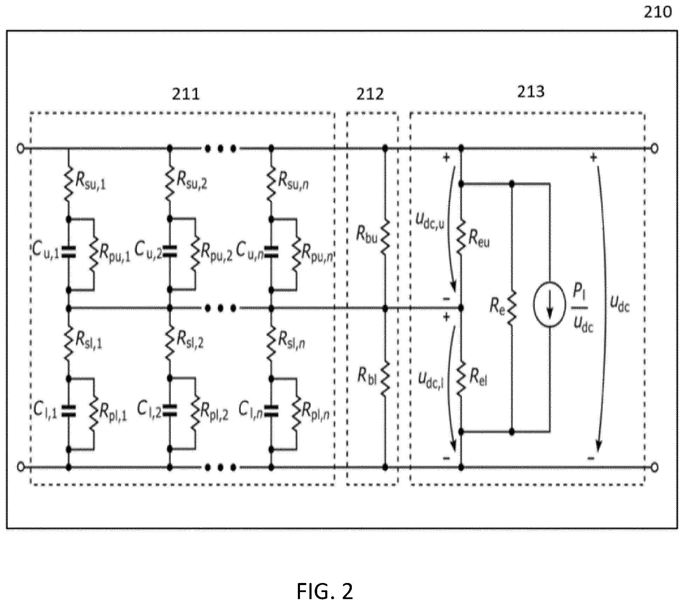

FIG. 2 illustrates an intermediate circuit model 210 according to an exemplary embodiment. In FIG. 2 it is assumed that the variable speed drive is in a stopped state.

Referring to FIG. 2, in the illustrated example the intermediate circuit model 210 comprises a capacitor bank 211, resistors 212 and electronics 213. They represent an example of the capacitor bank 111, the resistors 112 and the electronics 113 in FIG. 1.

The illustrated capacitor bank 211 comprises n capacitors in parallel, forming a sub-bank, and two sub-banks in series, each capacitor modelled with an equivalent circuit where C is the capacitance, $R_P$ is the equivalent parallel resistance modeling capacitor leakage current, and $R_S$ is the equivalent series resistance (ESR). It is to be noted that the two sub-banks in series are used herein for simplicity of the description and a number m of series connected capacitor sub-banks can be different from the two shown, such as three, four or more, or there are no series connection for sub-banks, i.e. m = 1. Further, in the illustrated example of FIG. 2, the intermediate circuit model is divided into upper and lower parts that are denoted with subscripts $u$ and $l$, respectively, in the circuit component names. For example, $C_{u,1}$ is the first parallel connected capacitance in the upper-branch, and $R_{pl,n}$ is the parallel resistance of the nth lower-branch capacitance.

The illustrated resistors 212 comprise the balancing/discharge resistances $R_{bu}$ and $R_{bl}$. It should be noted that for m series connected sub-banks, there are typically m balancing resistances, one for each sub-bank. A balancing resistance, e.g. $R_{bu}$ or $R_{bl}$, may be formed with series and parallel connections of suitable resistors.

The electronics 213 in FIG. 2 models active and passive electrical loads supplied from the intermediate circuit. These loads may include control boards and cooling fans of the drive as well as power supplies feeding the aforementioned. Passive, resistive, loads are modelled with resistances $R_e$, $R_{eu}$ and $R_{el}$ and active load with a current source $P_l/u_{dc}$, where $P_l$ is a load power.

As described above with FIG. 1, the electronics and control boards can be arranged to measure DC-voltage $u_{dc}$,

shortly voltage. In one embodiment, the electronics and control boards may be arranged to measure upper- and/or lower-branch voltages $u_{dc,u}$ and $u_{dc,l}$, respectively, or m sub-bank voltages in the case of m series connected capacitor sub-banks.

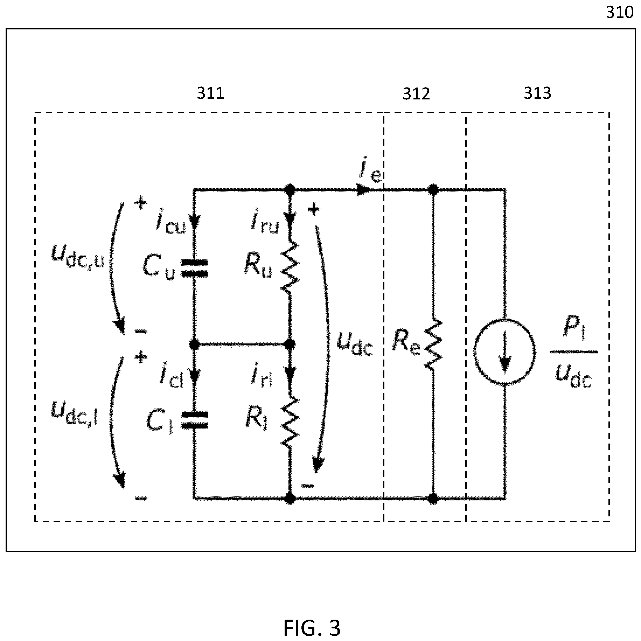

The intermediate circuit model depicted in FIG. 2 may be further simplified. FIG. 3 illustrates an equivalent circuit model 310 that is an example of a simplified model. In the illustrated example of FIG. 3, the equivalent circuit model 310 comprises an equivalent capacitor bank 311 representing the capacitor bank 211 of FIG. 2, equivalent resistor 312 representing the resistors 212 of FIG. 2, and equivalent circuit load 313 representing the electronics 213 of FIG. 2.

Different examples, that are based on the simplified equivalent model illustrated in FIG. 3, describing different ways to implement a parameter estimator are described below.

Since the ESRs of the capacitors in the intermediate circuit are typically some mΩ and the balancing resistances are in the range of kΩ, the ESRs of the capacitors can be ignored during the capacitor bank 311 energy discharge. Hence, the capacitance of the n parallel capacitors in the upper and lower branch can be combined to form equivalent capacitances as

$$C_u = \sum_{i=1}^{n} C_{u,i}$$

$$(1)$$

$$C_l = \sum_{i=1}^{n} C_{l,i}$$

$$(2)$$

The equivalent parallel resistances of the upper and lower branch capacitors, the balancing resistances, and other parallel resistances can be combined together as:

$$R_u = \left( \sum_{i=1}^{n} R_{pu,i}^{-1} + R_{bu}^{-1} + R_{eu}^{-1} \right)^{-1}$$

$$(3)$$

$$R_l = \left( \sum_{i=1}^{n} R_{pl,i}^{-1} + R_{bl}^{-1} + R_{el}^{-1} \right)^{-1}.$$

$$(4)$$

A model, e.g. a dynamic model, or equivalent model, modelling the intermediate circuit during discharge may be represented as:

$$C_u \frac{du_{dc,u}}{dt} = i_{cu} = -i_{ru} - i_e = -\frac{u_{dc,u}}{R_u} - \frac{u_{dc}}{R_e} - \frac{P_l}{u_{dc}},$$

$$(5)$$

$$C_l \frac{du_{dc,l}}{dt} = i_{cl} = -i_{rl} - i_e = -\frac{u_{dc,l}}{R_l} - \frac{u_{dc}}{R_e} - \frac{P_l}{u_{dc}}.$$

$$(6)$$

Alternative models may be based on variables $u_{dc}$ and $\Delta u_{dc}$ that are a sum and difference of the upper and lower branch voltages:

$$u_{dc} = u_{dc,u} + u_{dc,l}$$

$$(7)$$

$$\Delta u_{dc} = u_{dc,u} - u_{dc,l}$$

$$(8)$$

With equations (5), (6) and (7), they give:

$$\frac{du_{dc}}{dt} = -\frac{u_{dc,u}}{C_u R_u} - \frac{u_{dc,l}}{C_l R_l} - \frac{1}{C_{eq} R_e} u_{dc} - \frac{P_l}{C_{eq}} \frac{1}{u_{dc}}$$

$$(9)$$

where the equivalent capacitance is

$$C_{eq} = \frac{C_u C_l}{C_u + C_l}$$

$$(10)$$

Furthermore, inserting $u_{dc,u} = u_{dc} - u_{dc,l}$, into (9) gives:

$$\frac{du_{dc}}{dt} = \left(\frac{1}{C_u R_u} - \frac{1}{C_l R_l}\right) u_{dc,l} - \frac{u_{dc}}{C_u R_u} - \frac{1}{C_{eq} R_e} u_{dc} - \frac{P_l}{C_{eq}} \frac{1}{u_{dc}}$$

$$(11)$$

and inserting $u_{dc,l} = u_{dc} - u_{dc,u}$, into (9) gives:

$$\frac{du_{dc}}{dt} = \left(-\frac{1}{C_u R_u} + \frac{1}{C_l R_l}\right) u_{dc,u} - \frac{u_{dc}}{C_l R_l} - \frac{1}{C_{eq} R_e} u_{dc} - \frac{P_l}{C_{eq}} \frac{1}{u_{dc}}$$

$$(12)$$

From the sum of (11) and (12), it follows that:

$$\frac{du_{dc}}{dt} = \frac{C_u R_u - C_l R_l}{2 C_l C_u R_l R_u} \Delta u_{dc} - \frac{C_u R_u + C_l R_l}{2 C_l C_u R_l R_u} u_{dc} - \frac{1}{C_{eq} R_e} u_{dc} - \frac{P_l}{C_{eq}} \frac{1}{u_{dc}}$$

$$(13)$$

Assuming that $C_u \approx C_l$ and $R_u \approx R_l$, upper and lower branch resistances can be approximated using their average as:

$$R_p = \frac{R_u + R_l}{2} \approx R_u \approx R_l \qquad (14)$$

Inserting (14) to (13) gives:

$$\frac{du_{dc}}{dt} \approx \frac{(C_u - C_l)}{2C_l C_u R_p}\Delta u_{dc} - \frac{(C_u + C_l)}{2C_l C_u R_p}u_{dc} - \frac{1}{C_{eq}R_e}u_{dc} - \frac{P_l}{C_{eq}}\frac{1}{u_{dc}} \qquad (15)$$

(15) represent another model, e.g. a dynamic model, or equivalent model, modelling the intermediate circuit. It can be further simplified to:

$$\frac{du_{dc}}{dt} \approx \frac{(C_u - C_l)}{C_l C_u(R_u + R_l)}\Delta u_{dc} - \frac{1}{C_{eq}R_e}u_{dc} - \frac{P_l}{C_{eq}}\frac{1}{u_{dc}} \qquad (16)$$

where the equivalent resistance is

$$R_{eq} = \frac{2R_e R_p}{R_e + 2R_p} = \frac{R_e(R_u + R_l)}{R_e + R_u + R_l} \qquad (17)$$

When the voltage difference between the upper and lower branches stays small, i.e. the upper and lower branches are similar and $\Delta u_{dc} = u_{dc,u} - u_{dc,l} \ll u_{dc}$, the model (16) can be further simplified to capture dominant characteristics in $u_{dc}$ as

$$\frac{du_{dc}}{dt} = -\frac{1}{C_{eq}R_{eq}}u_{dc} - \frac{P_l}{C_{eq}}\frac{1}{u_{dc}} \qquad (18)$$

It should be appreciated that it is a straightforward task for one skilled in the art to apply the model (18) when a number of series connected capacitor sub-banks differ from two, such as m = 1, m = 3, or m = 4. For example, if three sub-banks are connected in series, there is a middle part between the upper and lower parts of the intermediate circuit. In this case, when the three voltage differences $\Delta u_{dc} = u_{dc,u} - u_{dc,l} \ll u_{dc}$, $\Delta u_{dc,u} = u_{dc,u} - u_{dc,m} \ll u_{dc}$, and $\Delta u_{dc,l} = u_{dc,m} - u_{dc,l} \ll u_{dc}$, where $u_{dc,m}$ is the middle part voltage, stay small, the three parts are similar and can be combined to form equivalent capacitance $C_{eq}$ and resistance $R_{eq}$, using circuit theory and the model (18) can be applied.

In a steady state, before the capacitor bank energy discharge in the stopped state, the energy consumed by the intermediate circuit is fed from AC supply network and it can be assumed that

$$\frac{du_{dc}}{dt} = \frac{du_{dc,u}}{dt} = \frac{du_{dc,l}}{dt} = 0 \qquad (19)$$

The currents in the equivalent parallel resistors $R_u$ and $R_l$ are equal, $i_{ru} = i_{rl}$. Furthermore, the following voltage divisions are obtained

$$\bar{u}_{dc,l} = \frac{R_l}{R_u + R_l}\bar{u}_{dc} \text{ and } \bar{u}_{dc,u} = \frac{R_u}{R_u + R_l}\bar{u}_{dc}$$

$$(\,20\,)$$

where overbar denotes a voltage value, or an average voltage value, in the steady state. The voltage division gives a ratio

$$\frac{R_u}{R_l} = \frac{\bar{u}_{dc,u}}{\bar{u}_{dc,l}}$$

$$(\,21\,)$$

The ratio can be used to check whether the assumption (14) is valid. If $\frac{\bar{u}_{dc,u}}{\bar{u}_{dc,l}} \approx 1$ then the assumption (14) is valid. Given that the ratio is initially unity but the ratio starts deviating from unity during the life-time of the intermediate circuit, the ratio may indicate changes in the resistive parts of the intermediate circuit. In the case where number of series connected capacitor sub-banks differ from m = 2, such as m = 3 or m = 4, the total DC voltage value may be divided to m parts. Then, comparing these m voltage values or their ratios, it can be determined whether the m resistive parts are similar.

Inserting an equivalent time constant $\tau = C_{eq}R_{eq}$ and a power-to-capacitance ratio $\beta = \frac{P_l}{C_{eq}}$ to the model (18), following non-linear dynamic model is obtained.

$$\frac{du_{dc}}{dt} = -\frac{u_{dc}}{\tau} - \frac{\beta}{u_{dc}}$$

$$(\,22\,)$$

A parameter estimator may be based on the non-linear dynamic model and estimate its parameters, which may comprise a first parameter and a second parameter. The first parameter may be the equivalent time constant $\tau$. The second parameter that may be the power-to-capacitance ratio $\beta$. If the power $P_l$ depends on DC voltage level, i.e. $P_l(u_{dc})$ is not constant, piece-wise constants $P_l$ and $\beta$ can be used in the model (22), and in a corresponding parameter estimator.

Herein, parameter estimates are marked with a hat, e.g. $\hat{\tau} = \hat{C}_{eq}\hat{R}_{eq}$ depicts an estimated first parameter and $\hat{\beta} = \frac{\hat{P}_l}{\hat{C}_{eq}}$ depicts an estimated second parameter.

For linear systems, the non-linear dynamic model (22) may be further linearized using square of $u_{dc}$ as a state variable as:

$$\frac{1}{2}\frac{du_{dc}^2}{dt} = -\frac{u_{dc}^2}{\tau} - \beta$$

$$(\,23\,)$$

further written in discretized (sampled-data) form applying forward Euler method, resulting:

$$\frac{1}{2}\frac{u_{dc}^2(k+1) - u_{dc}^2(k)}{T_s} = -\frac{u_{dc}^2(k)}{\tau} - \beta$$

$$(\,24\,)$$

where $k$ is the discrete-time index and $T_s$ is the sampling interval.

For a corresponding linearized and discretized parameter estimator, the discretized form may be further written in regression form:

$$y(k) = \underbrace{\frac{1}{2}[u_{dc}^2(k) - u_{dc}^2(k-1)]}_{y(k)} = \underbrace{-\frac{T_s}{\tau}}_{a}\underbrace{u_{dc}^2(k-1)}_{x(k)} + \underbrace{-T_s\beta}_{b} = a\,x(k) + b$$

$$(25)$$

where $a$ and b are the first and second parameters the parameter estimator comprises.

The regressed (measured) variable

$$y(k) = \frac{1}{2}[u_{dc}^2(k) - u_{dc}^2(k-1)]$$

$$(26)$$

can be expressed as $y(k) = \phi^T\theta$, where

$$\phi(k) = [x(k) \quad 1]^T = [u_{dc}^2(k-1) \quad 1]^T$$

$$(27)$$

is the regressor vector and

$$\theta = [a, b]^T = [-\frac{T_s}{\tau} \quad -T_s\beta]^T$$

$$(28)$$

represents a parameter vector to be estimated in one exemplary embodiment of a parameter estimator, where the parameter vector comprises parameters that are to be estimated. The parameter estimator may be configured to calculate a parameter estimate $\hat\theta$, for example, using recursive linear least squares method as:

$$\hat\theta(k) = \hat\theta(k-1) + K(k)\epsilon(k)$$

$$(29)$$

$$\epsilon(k) = y(k) - \phi^T(k)\hat\theta(k-1)$$

$$(30)$$

$$K(k) = P(k)\phi(k) = \frac{P(k-1)\phi(k)}{\lambda + \phi^T(k)P(k-1)\phi(k)}$$

$$(31)$$

$$P(k) = \frac{1}{\lambda}(P(k-1) - \frac{P(k-1)\phi(k)\phi^T(k)P(k-1)}{\lambda + \phi^T(k)P(k-1)\phi(k)})$$

$$(32)$$

where $\varepsilon$ is the prediction error, $K$ is the gain, P is the covariance matrix, and $\lambda$ is the forgetting factor. In another exemplary embodiment, a recursive prediction error method or some other method suitable for the model structure (25) could be used instead of the recursive linear least squares method.

In one exemplary embodiment, a parameter estimator implementing the equations (26) to (32) takes measured DC voltage samples as inputs and recursively calculates, and updates following parameter vector

$$\hat{\theta} = [\hat{a}, \hat{b}]^T = [-\frac{T_s}{\hat{\tau}} \quad -T_s\hat{\beta}\,]^T$$

$$(33)$$

when DC voltage samples are input.

The parameter estimator according to this implementation may output values of two independent parameters $\hat{a}$ and $\hat{b}$, the output values being first values for the time constant and second values for the power-to-capacitance ratio. The values can further be mapped to estimated time constant $\hat{\tau} = -T_s/\hat{a}$ and power-to-capacitance ratio $\hat{\beta}$ when the sampling interval $T_s$ is known. Furthermore, the estimated time constant and the estimated power-to-capacitance ratio can be related to equivalent circuit parameters as $\hat{\tau} = \hat{C}_{eq}\hat{R}_{eq}$ and $\hat{\beta} = \dfrac{\hat{P}_l}{\hat{C}_{eq}}$ .

In another implementation, the regressed variable for a linearized and discretized parameter estimator can be written as:

$$y(k) = \underbrace{\frac{1}{2}\frac{-u_{dc}^2(k+1) + u_{dc}^2(k)}{T_s}}_{y(k)} = \underbrace{\tau}_{a}\underbrace{u_{dc}^2(k-1)}_{x(k)} + \underbrace{\beta}_{b} = a\,x(k) + b$$

$$(34)$$

where $a$ and $b$ are the first and second parameters of the parameter estimator. In the implementation, the regressed (measured) variable is obtained by diving by sampling interval and multiplying by -1:

$$y(k) = \frac{1}{2}\frac{-u_{dc}^2(k+1) + u_{dc}^2(k)}{T_s}$$

$$(35)$$

This can be further expressed as $y(k) = \phi^T(k)\theta$, where $\phi(k) = [x(k) \quad 1]^T = [u_{dc}^2(k-1) \quad 1]^T$ , i.e. $\phi(k)$ remains same as earlier (see equation 27). Alternatively, multiplication by -1 can be included in the elements of $\phi$ instead of $y$. The regressor vector is directly containing the estimated time constant and power-to-capacitance ratio as:

$$\theta = [a, b]^T = [\tau \;\; \beta\,]^T$$

$$(36)$$

The parameter estimator estimating a parameter vector represented by (36) can be implemented in a similar manner as presented earlier. In this implementation, the parameter estimator may output estimated time constant values as the first values and estimated power-to-capacitance ratio values as the second values.

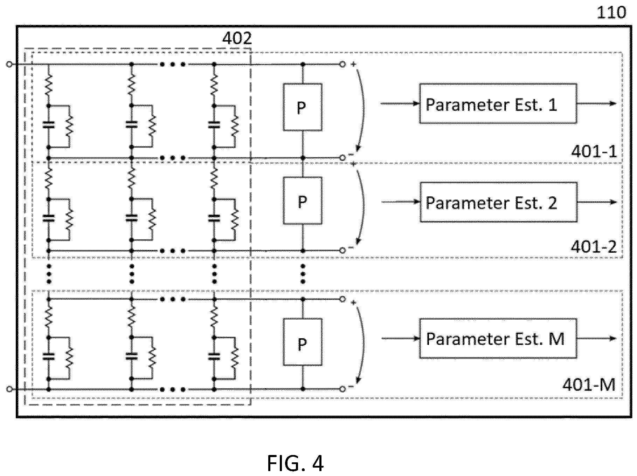

FIG. 4 illustrates a non-limiting example how to implement the above examples to an intermediate circuit comprising a plurality of sub-circuits and configured to measure voltages per a sub-circuit.

Referring to FIG. 4, capacitors in the plurality of sub-circuits 401-1, 401-2, 401-M in the intermediate circuit model 110 form a capacitor bank 402 corresponding to the capacitor bank 211 in FIG. 2. However, in the example illustrated in FIG. 4, there is a plurality of parameter estimators, an estimator per a sub-circuit. Since voltages are measured per a sub-circuit, the parameter estimators in the sub-circuits can be implemented as described above, the only difference being that the values of the first parameter and the second parameter in a parameter estimator for a sub-circuit are based on values of the sub-circuit, not on values of the intermediate circuit, and the values that the parameter estimator outputs are values for time constant of the sub-circuit and for power-to-capacitance ratio of the sub-circuit.

The benefit of having a plurality of estimators (one per a sub-circuit) is that sub-circuits can be independently monitored and possible differences in the sub-circuits can be detected. The differences may indicate a developing fault better than an implementation in which sub-circuits share a common parameter estimator.

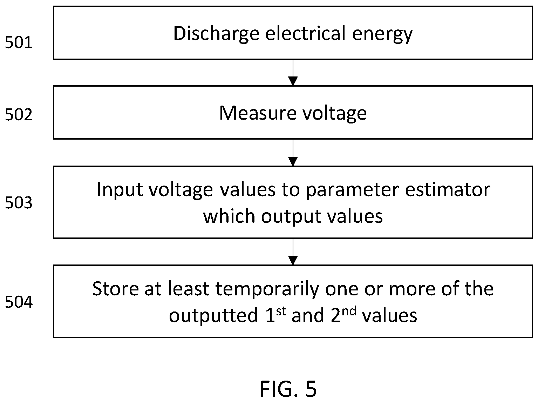

FIG. 5 is a flowchart illustrating an example functionality. The functionality may be performed by an apparatus, such as a variable speed drive, comprising an intermediate circuit, or a component comprised in the apparatus, when the apparatus is disconnected from an AC supply network.

Referring to FIG. 5, electrical energy is discharged (block 501) from the intermediate circuit. The electrical energy discharge may be a capacitor-bank energy discharge. During the electrical energy discharge, a DC voltage is measured (block 502) from the intermediate circuit. The measurement may be performed by sampling the DC voltage with a sampling interval $T_s$. The measured DC voltage values are inputted (block 503) to a parameter estimator, examples of which are described above. Depending on the implementation, the measured DC voltage values may be inputted to the parameter estimator in a real time, resulting the parameter estimator being updated recursively during the energy discharge, or the measured DC voltage values may be temporarily stored for batch processing, i.e. the measured values are input to the parameter estimator later as a batch job.

The parameter estimator outputs at least first values for time constant and second values for power-to-capacitance ratio. Different examples of the first values and the second values are described above. One or more of the outputted first values, and one or more of the outputted second values may be at least temporarily stored (block 504) in at least one memory. For example, at least one first value for the time constant stored at least temporarily may be the last first value, and/or an average of the first values, and/or a subset of the first values, and/or a median of the first values, and/or the last X first values, and/or an average of the last X first values, and/or every Nth first value, and/or all first values. Correspondingly, the at least one second value for the power-to-capacitance ratio stored may be the last second value, and/or an average of the second values, and/or a subset of second values, and/or a median of the second values, and/or the last X second values, and/or an average of the last X second values, and/or every Nth second value, and/or all second values.

In an embodiment, the above values are stored for condition monitoring in the at least one memory. The at least one memory may comprise memory in the apparatus, and/or memory in the intermediate circuit and/or memory in a control board, and/or memory in the component, and/or external data storage, such as the cloud.

In some exemplary embodiment, the output values that are stored temporarily to the memory are further processed for determining corresponding values for the equivalent capacitance. Since the time constant and the power-to-capacitance ratio are related to equivalent circuit parameters as $\hat{\tau} = \hat{C}_{eq}\hat{R}_{eq}$ and $\hat{\beta} = \dfrac{\hat{P}_l}{\hat{C}_{eq}}$, the value for the equivalent capacitance C can be determined from the temporarily stored values, when at least one of the equivalent resistance value or the equivalent electrical load power value is known. The thus determined values, or at least one value, for the equivalent capacitance are stored to the at least one memory. Examples of memories are given above.

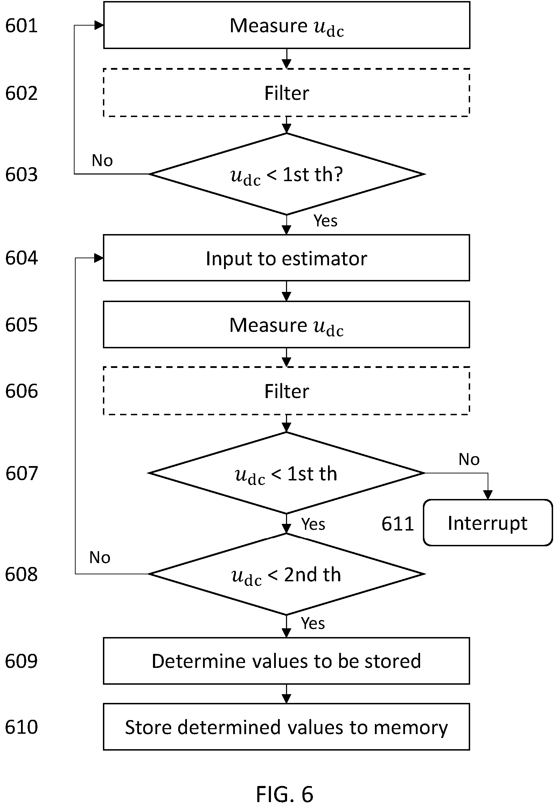

FIG. 6 is a flowchart illustrating an example functionality in which a parameter estimator is used in real-time. It is a straightforward task for the person skilled in the art to implement the functionality when batch processing is used. The functionality may be performed by an apparatus, such as a variable speed drive, comprising an intermediate circuit, or a component comprised in the apparatus, when the apparatus is disconnected from an AC supply network.

Referring to FIG. 6, electrical energy is discharged from the intermediate circuit and during the electrical energy discharge, a DC voltage of the intermediate circuit is measured (block 601).

Optionally, for example, when the measured DC voltage is noisy, the measured DC voltage $u_{dc}$ may be filtered (block 602). A filter can be, for example, a first-order low-pass filter.

The measured DC voltage of intermediate circuit or the measured and filtered DC voltage of the intermediate circuit, both denoted in the example $u_{dc}$, and called herein simply measured voltage, is compared (block 603) to a predefined first threshold value. The first predefined threshold value can be for example 60...90 % of the normal steady-state DC voltage level. The measuring (block 601), optionally filtering (block 602) and comparing (block 603) the measured voltage to the first threshold, is performed as long as the measured voltage is not (block 603: no) below the first threshold value.

In the example of FIG. 6, when the measured voltage is below the first threshold value (block 603: yes), the measured voltage is inputted (block 604) to the parameter estimator. (The parameter estimator may output values during this, the values may be used by it recursively, and the values may be stored to a volatile memory, for example.) Examples of the parameter estimator are described above with FIG. 3 and FIG. 4. Then the process continues the measuring (block 605) and optionally filtering (block 606) DC voltage of the intermediate circuit, as described with blocks 601 and 602. The measured voltage is compared (block 607) to the predefined first threshold. When the measured voltage remains below (block 607: yes) the first threshold value, the measured voltage is compared (block 608) to a predefined second threshold.

The second threshold value may depend on the architecture of the drive, and it can be for example 10...20 % of the steady-state DC voltage level.

As long as the measured voltage remains below the first threshold (block: yes) and above the second threshold (block: no), the process returns to block 604 to input the measured voltage to the parameter estimator.

When the measured voltage is determined (block 608: yes) to be below the second threshold, at least one first value for the time constant, outputted by the parameter estimator, and at least one second value for the power-to-capacitance ratio, outputted by the parameter estimator, to be stored at least temporarily are determined (block 609). For example, the determining may comprise selecting, as a value for the time constant, the last first value, and/or an average of the first values, and/or a subset of first values, and/or a median of the first values, and/or the last X first values, and/or an average of the last X first values, and/or every Nth first value, and/or all first values. Correspondingly, the determining may comprise selecting, as a value for the power-to-capacitance ratio, the at the last second value, and/or an average of the second values, and/or a subset of second values, and/or a median of the second values, and/or the last X second values, and/or an average of the last X second values, and/or every Nth second value, and/or all second values. The determined values are then at least temporarily stored (block 610) to memory, as described above with block 504. With the use of the second threshold value it is ensured that the intermediate circuit will have enough power left for the apparatus to perform the determining and storing.

If the measured voltage increases (block 607: no) above the first threshold after it has been below it (block 603: yes), the process is interrupted (block 611). In other words, the DC voltage measurements are interrupted without storing values output by the parameter estimator. Naturally, the process may be interrupted for any other reason as well. For example, an operator may interrupt the process manually, by inputting a corresponding command.

In the implementation using batch processing, the measured voltage values may be temporarily stored to the memory, to be inputted to the parameter estimator later as a batch job.

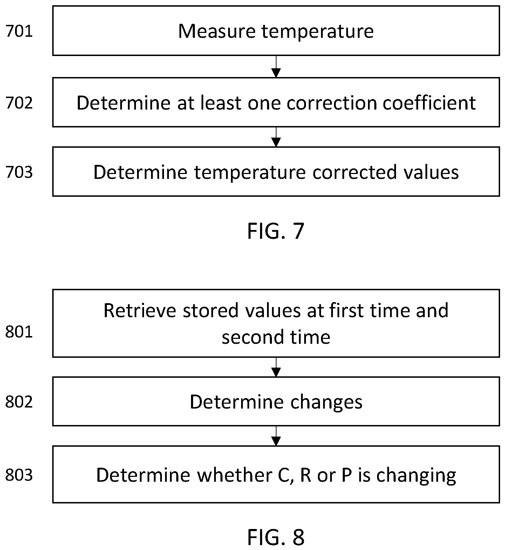

Performance of the apparatus comprising the intermediate circuit, such as the variable speed drive, may vary based on environmental conditions. Usually, the environmental conditions varies thereby affecting performance of the intermediate circuit. For example, the capacitance and leakage current of capacitors depend on temperature $T$. Hence, the equivalent capacitance $C_{eq} = C_{eq}(T)$ and equivalent resistance $R_{eq} = R_{eq}(T)$ are temperature dependent. FIG. 7 illustrates an example functionality how temperature changes in the location can be compensated for when the temperature dependencies of $C_{eq}(T)$ and $R_{eq}(T)$ are known, and hence a temperature dependency between a measured temperature and a reference temperature may be predefined to obtain correction coefficients.

Referring to FIG. 7, a temperature is measured (block 701) during the DC voltage discharge. The measured temperature may be, for example, ambient temperature, a temperature measured on a surface of the capacitor bank, a temperature measured inside the apparatus, e.g. inside the variable-speed drive, etc. At least one correction coefficient can be determined (block 702) using a predefined temperature dependency between the measured temperature and a reference temperature. In most use cases correction coefficients are determined (block 702) for both the time constant and the power-to-capacitance ratio using corresponding predefined temperature dependencies. With the determined correction coefficient(s), corrected values for the time constant and the power-to-capacitance ratio can be determined (block 703). For example, using the at least one first value, outputted by the parameter estimator, for the time constant and equivalent correction coefficient for time constant values, at least one temperature corrected value for the time constant can be determined. Correspondingly, using the at least one second value, outputted by the parameter estimator, for the power-to-capacitance ratio and equivalent correction coefficient for the power-to-capacitance ratio at least one temperature corrected value for the power-to-capacitance ratio can be determined. In other words, the compensation can be performed by mapping $\hat{\tau}$ and $\beta$ estimated in a temperature $T$ to the reference temperature $T_{ref}$ with the known temperature dependency.

In the non-limiting example of FIG.7, the temperature correction is performed to first values and second values when they are outputted by the parameter estimator, i.e. while measuring the DC voltage values. In one exemplary embodiment, the measured temperatures are stored to memory in such a way that they can be associated with corresponding first and second values, enabling postponement of the temperature compensation. In other words, blocks 702 and 703 can be performed later, and possibly by another apparatus, e.g. by the operator equipment.

FIG. 8 is a flowchart illustrating an example functionality of an apparatus that is configured to perform condition monitoring using the values stored for the condition monitoring of the internal circuit. In the non-limiting example of FIG. 8 it is assumed that the values stored are first values for the time constant and second values for the power-to-capacitance ratio, and that the values are temperature corrected values if temperature corrections are needed. The first values and second values are determined with the parameter estimator. Examples of the parameter estimator are described above with FIG. 3 and FIG. 4. The apparatus performing the functionality may be an operator equipment.

Referring to FIG. 8, previously stored values are retrieved (block 801) from the memory. For example, values stored at a first time and values stored at a second time, the second time preceding the first time, may be retrieved from the memory. In the illustrative example, a change (a possible change) is determined (block 802) for both the time constant and the power-to-capacitance ratio. To determine whether the time constant is changing a time constant value at the first time is compared to a time constant value at the second time. To determine whether the capacitance ratio is changing is performed accordingly by comparing a power-to-capacitance ratio value at the first time to a power-to-capacitance ratio value at the second time. In other words, the condition monitoring of the intermediate circuit may be performed by comparing changes of output values determined at different times and, and hence stored at different times. This also enables to create a discharge voltage time curve to be monitored.

Based on the determined changes for both the time constant and the power-to-capacitance ratio, it can be determined (block 803) whether any of the equivalent capacitance value of the intermediate circuit, the equivalent resistance value of the intermediate circuit, or the electrical load power value of the intermediate circuit is changing.

For example, based on the changes determined in block 803, following may be determined:

The equivalent capacitance value of the intermediate circuit is decreasing when the change in time constant value indicates a decrease and the change in power-to-capacitance ratio value indicates an increase.

The equivalent capacitance value of the intermediate circuit is increasing when the change in time constant value indicates an increase and the change in power-to-capacitance ratio value indicates a decrease.

The equivalent resistance value of the intermediate circuit is decreasing when the change in time constant value indicates a decrease and the change in power-to-capacitance ratio value indicates no change.

The equivalent resistance value of the intermediate circuit is increasing when the change in time constant value indicates an increase and the change in power-to-capacitance ratio value indicates no change.

The electrical load power value of the intermediate circuit is decreasing when the change in time constant value indicates no change and the change in power-to-capacitance ratio value indicates a decrease.

The electrical load power value of the intermediate circuit is increasing when the change in time constant value indicates no change and the change in power-to-capacitance ratio value indicates an increase.

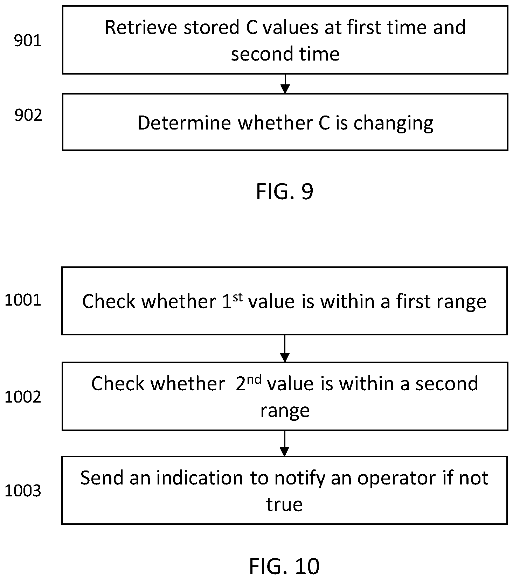

FIG. 9 is a flowchart illustrating an example functionality of an apparatus that is configured to perform a condition monitoring using the values stored for the condition monitoring of the internal circuit. In the non-limiting example of FIG. 9 it is assumed that the values stored are capacitance values and that the values are temperature corrected values, if temperature correction is needed. The apparatus may be an operator equipment, for example.

Referring to FIG. 9, the stored capacitance values are retrieved (block 901) from the memory. For example, a capacitance value stored at a first time and a capacitance value stored at a second time, the second time preceding the first time, may be retrieved from the memory. To determine (block 902) whether the capacitance value is changing, the capacitance value at the first time is compared with the capacitance value at the second time. If the value at the first time is higher than the value at the second time, the capacitance value is decreasing. If the value at the first time is lower than the value at the second time, the capacitance value is increasing. If the value at the first time is same as the value at the second time, the capacitance value has not changed.

FIG. 10 is a flowchart illustrating an example functionality of an apparatus that is configured to monitor whether the first and second output values of the parameter estimator are within corresponding predetermined ranges. Examples of the parameter estimator are described above with FIG. 3 and FIG. 4. The functionality may be performed by an apparatus, such as a variable speed drive, comprising an intermediate circuit, or a component comprised in the apparatus, when the apparatus is disconnected from an AC supply network, or by an operator equipment.

Referring to FIG. 10, it is checked (block 1001) whether the first value is within a first range. Correspondingly, it is checked (block 1002) whether the second value is within a second range. The first range is defined by a first upper limit and a first lower limit, where the first upper limit and the first lower limit are predefined limits. The second range, which may be different than the first range, is defined by a second upper limit and a second lower limit, where the second upper limit and the second lower limit are predefined limits of DC voltages. An apparatus sends (block 1003) an indication to an operator equipment, for example, to notify an operator. Depending on an implementation an operator may be notified, when the first value is not within the first range, or the second value is not within the second range, or the operator may be notified only when both the first value and the second value are not within their corresponding ranges.

As can be seen from the above, in the disclosed solutions, discharge voltage time curve, for example, can be monitored without using current measuring sensors or dedicated test loads, and yet the accuracy of the condition monitoring is not compromised. The accuracy of the condition monitoring is further increased in the solutions by including to the parameter estimator, and hence to estimations, the electrical load power that is present during the discharge and may change. This is an improvement compared to the state-of-the art methods that fail if the electrical load power is not always constant when values to be used in condition monitoring are obtained.

The blocks and related functions described above with respect to FIG. 5 to FIG. 10 are in no absolute chronological order, and some of the blocks may be performed simultaneously or in an order differing from the given one. Other functions may also be executed between the blocks or within the blocks. Some of the blocks or parts of the blocks may also be left out or replaced by a corresponding block or a part of a block.

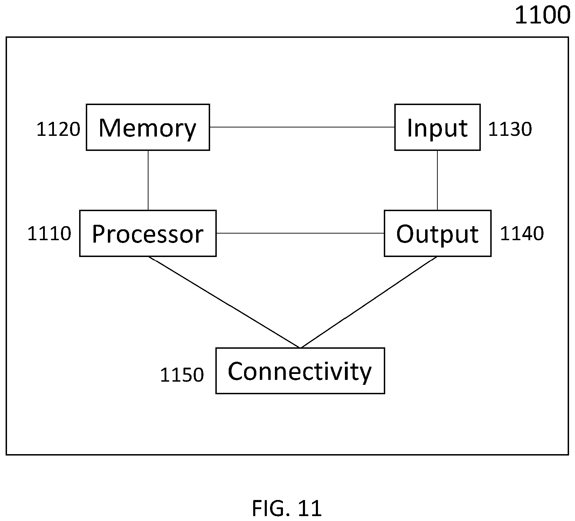

FIG. 11 illustrates an apparatus 1100, which may be an apparatus such as, a variable speed drive, an operator equipment, or an apparatus comprised in, e.g., an industrial equipment, a pump, a motor, or any other computing device. The apparatus 1100 may input measured values to the parameter estimator and store the parameter estimator output values to memory and/or store the measured values to memory and retrieve the values for parameter estimator as an input. The apparatus 1100 comprises a processor 1110. The processor 1110 interprets computer program instructions and processes data. The processor 1010 may comprise one or more programmable processors. The processor 1110 may comprise programmable hardware with embedded firmware and may, alternatively or additionally, comprise one or more application-specific integrated circuits (ASICs).

The processor 1110 is coupled to a memory 1120. The processor is configured to read and write data to and from the memory 1120. The memory 1020 may comprise one or more memory units. The memory units may be volatile or non-volatile. It is to be noted that in some exemplary embodiments there may be one or more units of non-volatile memory and one or more units of volatile memory or, alternatively, one or more units of non-volatile memory, or, alternatively, one or more units of volatile memory. Volatile memory may be for example random-access memory (RAM), dynamic random-access memory (DRAM) or synchronous dynamic random-access memory (SDRAM). Non-volatile memory may be for example read-only memory (ROM), programmable read-only memory (PROM), electronically erasable programmable read-only memory (EEPROM), flash memory, optical storage or magnetic storage. In general, memories may be referred to as non-transitory computer readable media. The memory 1120 stores computer readable instructions that are executed by the processor 1110. For example, non-volatile memory stores the computer readable instructions and the processor 1110 executes the instructions using volatile memory for temporary storage of data and/or instructions.

The computer readable instructions may have been pre-stored to the memory 1120 or, alternatively or additionally, they may be received, by the apparatus, via an electromagnetic carrier signal and/or may be copied from a physical entity such as a computer program product. Execution of the computer readable instructions causes the apparatus 1100 to perform one or more of the functionalities described above.

In the context of this document, a "memory" or "computer-readable media" or "computer-readable medium" may be any non-transitory media or medium or means that can contain, store, communicate, propagate or transport the instructions for use by or in connection with an instruction execution system, apparatus, or device, such as a computer.

The apparatus 1100 may further comprise, or be connected to, an input unit 1130. The input unit 1130 may comprise one or more interfaces for receiving input. The one or more interfaces may comprise for example one or more voltage, temperature, motion and/or orientation sensors, one or more cameras, one or more accelerometers, one or more microphones, one or more buttons and/or one or more touch detection units. Further, the input unit 1130 may comprise an interface to which external devices may connect to.

The apparatus 1100 may also comprise an output unit 1140. The output unit may comprise or be connected to one or more displays capable of rendering visual content, such as a light emitting diode (LED) display, a liquid crystal display (LCD) and/or a liquid crystal on silicon (LCoS) display. The output unit 1140 may further comprise one or more audio outputs. The one or more audio outputs may be for example loudspeakers.

The apparatus 1100 further comprises a connectivity unit 1150. The connectivity unit 1150 enables wired and/or wireless connectivity to one or more external devices. The connectivity unit 1150 may comprise at least one transmitter and at least one receiver that may be integrated to the apparatus 1100 or that the apparatus 1100 may be connected to. The connectivity unit 1150 may comprise an integrated circuit or a set of integrated circuits that provide the communication capability for the apparatus 1100. Alternatively, the connectivity may be a hardwired application-specific integrated circuit (ASIC). The connectivity unit 1150 may comprise one or more components such as a power amplifier, digital front end (DFE), analog-to-digital converter (ADC), digital-to-analog converter (DAC), frequency converter, (de)modulator, and/or encoder/decoder circuitries, controlled by the corresponding controlling units.

It is to be noted that the apparatus 1100 may further comprise various components not illustrated in FIG. 11. The various components may be hardware components and/or software components.

The techniques and methods described herein may be implemented by various means. For example, these techniques may be implemented in hardware (one or more devices), firmware (one or more devices), software (one or more modules), or combinations thereof. For a hardware implementation, the apparatus(es) of exemplary embodiments may be implemented within one or more application-specific integrated circuits (ASICs), digital signal processors (DSPs), digital signal processing devices (DSPDs), programmable logic devices (PLDs), field programmable gate arrays (FPGAs), graphics processing units (GPUs), processors, controllers, micro-controllers, microprocessors, other electronic units designed to perform the functions described herein, or a combination thereof. For firmware or software, the implementation can be carried out through modules of at least one chipset (for example procedures, functions, and so on) that perform the functions described herein. The software codes may be stored in a memory unit and executed by processors. The memory unit may be implemented within the processor or externally to the processor. In the latter case, it can be communicatively coupled to the processor via various means, as is known in the art. Additionally, the components of the systems described herein may be rearranged and/or complemented by additional components in order to facilitate the achievements of the various aspects, etc., described with regard thereto, and they are not limited to the precise configurations set forth in the given figures, as will be appreciated by one skilled in the art.

It will be obvious to a person skilled in the art that, as technology advances, the inventive concept may be implemented in various ways. The embodiments are not limited to the exemplary embodiments described above but may vary within the scope of the claims. Therefore, all words and expressions should be interpreted broadly, and they are intended to illustrate, not to restrict, the exemplary embodiments.

**Claims**

1. A computer-implemented method comprising:

   discharging, when alternating current, AC, is not supplied to an apparatus, electrical energy from an intermediate circuit comprised in the apparatus;
   measuring, during the discharging, a direct current, DC, voltage of the intermediate circuit;
   when the DC voltage of the intermediate circuit is below a first threshold value and above a second threshold value, inputting measured DC voltage values to a parameter estimator for the intermediate circuit, wherein the parameter estimator comprises at least a first parameter and a second parameter whose values are determined based on an equivalent capacitance value of the intermediate circuit, an equivalent resistance value of the intermediate circuit and an electrical load power value of the intermediate circuit, the parameter estimator outputting at least first values for time constant, and second values for power-to-capacitance ratio of the intermediate circuit;
   when the DC voltage of the intermediate circuit decreases below the second threshold value, storing, for condition monitoring, at least temporarily in at least one memory, at least one value for the time constant and at least one value for the power-to-capacitance ratio.

2. A method of claim 1 further comprising:
   recursively updating the value of the first parameter based on a first value and the value of the second parameter based on a second value before inputting a new measured DC voltage value to the parameter estimator.

3. A method of claim 1 or 2 further comprising:

   performing the measuring by sampling the DC voltage with a sampling interval; and
   determining estimated values for the time constant and the power-to-capacitance ratio based on the first values and the second values and the time interval.

4. A method of any preceding claim further comprising:

   checking whether the first value is within a first range defined by a first upper limit and a first lower limit;
   checking whether the second value is within a second range defined by a second upper limit and a second lower limit; and
   sending an indication to notify an operator when the first value is not within the first range and/or when the second value is not within the second range.

5. A method of any preceding claim further comprising filtering the measured DC voltage before inputting the DC voltage to the parameter estimator.

6. A method of any preceding claim further comprising, if the DC voltage increases above the first threshold value after being below the first threshold, interrupting the measuring and the inputting measured DC voltage values without performing the storing.

7. A method of any preceding claim further comprising:

   measuring a temperature during the discharging DC voltage of the intermediate circuit;
   determining at least one correction coefficient using a predefined temperature dependency between the measured temperature and a reference temperature;
   determining, using the at least one first value for the time constant and correction coefficient, at least one temperature corrected value for the time constant; and
   determining, using the at least one second value for the power-to-capacitance ratio and correction coefficient, at least one temperature corrected value for the power-to-capacitance ratio.

8. A method of any preceding claim, wherein the first threshold value and the second threshold value are predefined from a steady-state DC voltage level of the intermediate circuit.

9. A method of any preceding claim, wherein

the at least one value for the time constant stored is the last first value, and/or an average of the first values, and/or a subset of first values, and/or a median of the first values, and/or the last X first values, and/or an average of the last X first values, and/or every Nth first value, and/or all first values; and
the at least one value for the power-to-capacitance ratio stored is the last second value, and/or an average of the second values, and/or a subset of second values, and/or a median of the second values, and/or the last X second values, and/or an average of the last X second values, and/or every Nth second value, and/or all second values.

10. A method of any preceding claim, further comprising:

retrieving values stored for the condition monitoring at a first time and at a second time, the second time preceding the first time;
determining a first change by comparing a value for the time constant at the first time with a value for the time constant at the second time;
determining a second change by comparing a value for the power-to-capacitance ratio at the first time with a value for the power-to-capacitance ratio at the second time; and
determining based on the first change and the second change whether any of the equivalent capacitance value of the intermediate circuit, the equivalent resistance value of the intermediate circuit, or the electrical load power value of the intermediate circuit is changing.

11. A method of any preceding claims, further comprising, when at least one of the equivalent resistance value of the intermediate circuit or the equivalent load power value of the intermediate circuit is known:

determining from the at least one value for the time constant and the at least one value for the power-to-capacitance ratio stored at least temporarily, using the equivalent resistance value of the intermediate circuit or the electrical load power value of the intermediate circuit, an equivalent capacitance value;
storing the equivalent capacitance value for the condition monitoring;
retrieving equivalent capacitance values stored for the condition monitoring at a first time and at a second time, the second time preceding the first time;
determining whether the equivalent capacitance value is decreasing or increasing by comparing to the equivalent capacitance value at the first time with the equivalent capacitance value at the second time.

12. An apparatus comprising at least:

an intermediate circuit;
a parameter estimator for the intermediate circuit, the parameter estimator comprising at least a first parameter and a second parameter whose values are determined based on an equivalent capacitance value of the intermediate circuit, an equivalent resistance value of the intermediate circuit and an electrical load power value of the intermediate circuit, the parameter estimator outputting at least first values for time constant, and second values for power-to-capacitance ratio of the intermediate circuit;
means for discharging, when alternating current, AC, is not supplied to the apparatus, electrical energy from the intermediate circuit;
means for measuring, during the discharging, a direct current, DC, voltage of the intermediate circuit;
means for inputting, when the DC voltage of the intermediate circuit is below a first threshold value and above a second threshold value, the measured DC voltage values to the parameter estimator;
means for storing, when the DC voltage of the intermediate circuit decreases below the second threshold value, for condition monitoring, at least one value for the time constant and at least one value for the power-to-capacitance ratio and at least temporarily an equivalent capacitance value.

13. The apparatus of claim 12 further comprising means for performing the method of any of claims 2-9.

14. The apparatus of claim 12 or 13 wherein

the intermediate circuit comprises N sub-circuits, wherein N is a positive integer whose value is two or more;
N parameter estimators, a parameter estimator per a sub-circuit, wherein a parameter estimator for a sub-circuit comprises the first parameter and the second parameter for a sub-circuit time constant, the parameter estimator outputting at least first values for time constant and second values for power-to-capacitance ratio of sub-circuit;
means for measuring are configured to measure DC voltage per a sub-circuit;
means for inputting are configured to input DC voltage measured from a sub-circuit to a corresponding parameter estimator; and
means for further storing are configured to store first values and second values per a sub-circuit.

15. A computer program comprising instructions which, when the program is executed by a computer, cause the computer to carry out the method of any of claims 1-11.

FIG. 1

210

211        212         213

FIG. 2

310

311                    312         313

FIG. 3

FIG. 4

| 501 | Discharge electrical energy |
|---|---|

| 502 | Measure voltage |
|---|---|

| 503 | Input voltage values to parameter estimator which output values |
|---|---|

| 504 | Store at least temporarily one or more of the outputted 1st and 2nd values |
|---|---|

FIG. 5

FIG. 6

701 | Measure temperature

702 | Determine at least one correction coefficient

703 | Determine temperature corrected values

FIG. 7

801 | Retrieve stored values at first time and second time

802 | Determine changes

803 | Determine whether C, R or P is changing

FIG. 8

901 | Retrieve stored C values at first time and second time

902 | Determine whether C is changing

## FIG. 9

1001 | Check whether 1st value is within a first range

1002 | Check whether 2nd value is within a second range

1003 | Send an indication to notify an operator if not true

## FIG. 10

1100

FIG. 11

## EUROPEAN SEARCH REPORT

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | US 2024/171111 A1 (ALVI MUHAMMAD H [US] ET AL) 23 May 2024 (2024-05-23)<br>* paragraph [0010] - paragraph [0015] *<br>* paragraph [0035] - paragraph [0037] *<br>* paragraph [0052] *<br>* paragraph [0067] - paragraph [0068] *<br>* paragraph [0078] * | 1-15 | INV.<br>G01R31/64<br>G01R19/165<br>G01R31/40 |
| A | US 2024/321373 A1 (TRICHY NARASIMHAN [US] ET AL) 26 September 2024 (2024-09-26)<br>* paragraph [0034] - paragraph [0043] * | 1-15 | |
| A | US 2020/251982 A1 (FOUBE LAURENT [FR]) 6 August 2020 (2020-08-06)<br>* paragraph [0053] - paragraph [0067] * | 1-15 | |
| A | US 2017/149343 A1 (BHANDARKAR SANTOSH M [US] ET AL) 25 May 2017 (2017-05-25)<br>* paragraph [0008] - paragraph [0011] *<br>* paragraph [0029] * | 1-15 | |
| A | CHEN JIANLIANG ET AL: "An Online Condition Monitoring Method for Series-Connected Capacitors Using Auxiliary Discharging Network",<br>IEEE TRANSACTIONS ON INDUSTRIAL ELECTRONICS, IEEE SERVICE CENTER, PISCATAWAY, NJ, USA,<br>vol. 71, no. 8, 1 August 2024 (2024-08-01), pages 9747-9756, XP011967435,<br>ISSN: 0278-0046, DOI: 10.1109/TIE.2023.3327529<br>[retrieved on 2023-11-09]<br>* abstract * | 1-15 | TECHNICAL FIELDS SEARCHED (IPC)<br><br>G01R |

The present search report has been drawn up for all claims

| Place of search | Date of completion of the search | Examiner |
|---|---|---|
| Munich | 21 May 2025 | Kleiber, Michael |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P4C01)

## ANNEX TO THE EUROPEAN SEARCH REPORT
## ON EUROPEAN PATENT APPLICATION NO.

EP 24 21 6531

This annex lists the patent family members relating to the patent documents cited in the above-mentioned European search report.
The members are as contained in the European Patent Office EDP file on
The European Patent Office is in no way liable for these particulars which are merely given for the purpose of information.

21-05-2025

| Patent document cited in search report | Publication date | Patent family member(s) | Publication date |
|---|---|---|---|
| US 2024171111 A1 | 23-05-2024 | CN 118057196 A<br>DE 102023112125 A1<br>US 2024171111 A1 | 21-05-2024<br>23-05-2024<br>23-05-2024 |
| US 2024321373 A1 | 26-09-2024 | US 2024321373 A1<br>WO 2024196455 A1 | 26-09-2024<br>26-09-2024 |
| US 2020251982 A1 | 06-08-2020 | CN 111247439 A<br>EP 3477314 A1<br>JP 6896153 B2<br>JP 2020527024 A<br>US 2020251982 A1<br>WO 2019082535 A1 | 05-06-2020<br>01-05-2019<br>30-06-2021<br>31-08-2020<br>06-08-2020<br>02-05-2019 |
| US 2017149343 A1 | 25-05-2017 | CN 107064750 A<br>EP 3173802 A1<br>US 2017149343 A1 | 18-08-2017<br>31-05-2017<br>25-05-2017 |

EPO FORM P0459

For more details about this annex : see Official Journal of the European Patent Office, No. 12/82